# EUROPÄISCHE PATENTANMELDUNG

(11) **EP 1 237 198 A1**
(43) Veröffentlichungstag der Anmeldung: **04.09.2002**
(21) Anmeldenummer: 02100166.4
(22) Anmeldetag: 21.02.2002
(51) Int. Cl.: H01L 27/146

(54) **Strahlungssensor und Strahlungsdetektor für einen Computertomographen**

(30) Priorität: 22.02.2001 DE 10108430
(71) Anmelder: Philips Corporate Intellectual Property GmbH, 52066 Aachen (DE); Koninklijke Philips Electronics N.V., 5621 BA Eindhoven (NL)
(72) Erfinder: Vogtmeier, Gereon, Dr., Weisshausstrasse 2, 52066 Aachen (DE); Morales Serrano, Francisco, Dr., Weisshausstrasse 2, 52066 Aachen (DE); Schneider, Stefan, Dr., Weisshausstrasse 2, 52066 Aachen (DE); Such, Olaf, Dr., Weisshausstrasse 2, 52066 Aachen (DE)
(74) Vertreter: Volmer, Georg, Dipl.-Ing.

(57) **Zusammenfassung**

Die Erfindung betrifft einen Strahlungssensor (10), welcher insbesondere zur Verwendung im Strahlungsdetektor eines Computertomographen geeignet ist. Der vorzugsweise in CMOS-Technik als integrierter Chip hergestellte Strahlungssensor (10) enthält matrixartig angeordnete Photodioden (11) sowie mindestens einen Temperatursensor (12). Mit Hilfe der Ausgangssignale des Temperatursensors (12) können die Ausgangssignale der Photodioden (11) bezüglich ihrer Temperaturabhängigkeit korrigiert werden. Der Temperatursensor (12) verwendet vorzugsweise dasselbe Datenformat wie die Photodioden (11), so dass er von einer Auswerteeinheit (13) in gleicher Weise wie die Photodioden (11) adressiert, ausgelesen und verarbeitet werden kann. Der gemessene Temperaturwert kann weiterhin zur Erkennung von Fehlern und/oder einer Alterung des Strahlungssensor-Chips (10) verwendet werden.

## Beschreibung

Die Erfindung betrifft einen Strahlungssensor in integrierter Bauweise sowie einen Strahlungsdetektor mit mindestens einem derartigen Strahlungssensor und einer zugehörigen Auswerteeinheit.

Bei Strahlungssensoren in integrierter, mikroelektronischer Bauweise ist mindestens ein lichtund/oder röntgenstrahlenempfindliches Sensorelement auf einem Chip angeordnet, wobei das Sensorelement ein Ausgangssignal liefert, dessen Stärke die vom Sensorelement absorbierte Strahlungsmenge anzeigt. Ein solcher Röntgenstrahlungssensor ist z.B. in der DE 42 27 096 A1 offenbart. Strahlungssensoren, die für Licht und/öder Röntgenstrahlung empfindlich sind, werden in der DE 40 02 429 A1, der EP 0 434 154 B1 und der EP 0 440 282 B1 beschrieben. Typischerweise enthält ein solcher Strahlungssensor eine größere Anzahl von matrixartig angaordneten Sensorelementen. Die Sensorelemente könner zum Beispiel bei einem in CMOS-Technik realisierten Chip als Photodioden ausgebildet sein.

Der funktionale Zusammenhang zwischen dem Ausgangssignal eines Sensorelementes und der absorbierten Strahlungsmenge ist von verschiedenen Faktoren abhängig, wobei insbesondere die auf dem Chip herrschende Temperatur eine große Rolle spielt. Aus diesem Grunde ist es wünschenswert, die genannten Faktoren zu kompensieren, um den wahren Wert der absorbierten Strahlungsmenge genauer bestimmen zu können. Zur Erreichung dieses Ziels wird in der WO 99/03262 vorgeschlagen, auf einem Photosensor-Chip zwei der dort vorhandenen Photoelemente als Referenzelemente für Kompensationszwecke zu reservieren. Diese Referenzelemente werden nicht wie alle anderen Photoelemente dem zu messenden Licht ausgesetzt, sondern eines von ihnen wird durch eine metallische Schicht vom licht ganz abgeschirmt, während dem anderen ein externer elektrischer Strom aufgeprägt wird. Die beiden Referenzelemente repräsentieren somit den Zustand minimaler bzw. maximaler Beleuchtung eines lichtsensitiven Photoelementes, wobei die entsprechenden Ausgangssignale der Referenzelemente derselben Weiterverarbeitung unterworfen werden wie die Ausgangssignale der übrigen Photoelemente. Die so aus den beiden Referenzelementen gewonnenen Referenzwerte können von der Auswerteelektronik dazu verwendet werden, die Ausgangssignale der messenden Photoelemente entsprechend zu korrigieren. Auf diese Weise werden implizit verschiedene Störeinflüsse berücksichtigt, die sich auf die Erzeugung und Verarbeitung des Ausgangssignals eines lichtsensitiven Photoelementes auswirken können, also insbesondere Temperatur- und Spannungsschwankungen, herstellungsbedingte Toleranzen und dergleichen. Eine getrennte Erfassung der einzelnen Einflüsse ist allerdings nicht möglich.

Vor diesem Hintergrund war es Aufgabe der vorliegenden Erfindung, einen Strahlungssensor und ein Strahlungsdetektor bereitzustellen, welche insbesondere für die Verwendung in einem Computertomographen geeignet sind und welche eine differenzierte und zuverlässige Auswertung der Messwerte ermöglichen.

Diese Aufgabe wird durch einen Strahlungssensor mit den Merkmalen des Anspruchs 1, einen Strahlungssensor mit den Merkmalen des Anspruchs 2 sowie ein Strahlungsdetektor mit den Merkmalen des Anspruchs 7 gelöst. Vorteilhafte Ausgestaltungen sind in den Unteransprüchen enthalten.

Gemäß einer ersten Ausgestaltung enthält der Strahlungssensor in integrierter Bauweise mindestens ein licht- und/oder röntgenstrahlenempfindliches Sensorelement, dessen Ausgangssignal die von ihm absorbierte Strahlungsmenge anzeigt. Weiterhin enthält der Strahlungssensor mindestens einen Temperatursensor, dessen Ausgangssignal die am Temperatursensor vorherrschende Temperatur anzeigt.

Bei dieser Ausgestaltung wird somit ein Temperatursensor auf dem Chip des Strahlungssensors integriert, durch den eine direkte und genaue Bestimmung der Temperatur am Strahlungssensor möglich ist. Diese Temperatur entspricht der Temperatur, auf welcher sich das gesamte Strahlungssensor-Chip befindet, da dieses aufgrund seiner geringen Ausdehnung eine nahezu homogene Temperaturverteilung aufweist. Die exakte Anordnung des Temperatursensors ist daher in der Regel nicht kritisch. Vorzugsweise wird der Temperatursensor jedoch so angeordnet, dass er in jedem Falle einen möglichst repräsentativen Temperaturwert erfasst. Dies ist beispielsweise in der Mitte beziehungsweise an einer symmetrisch gelegenen Position auf dem Chips der Fall.
Durch die Kenntnis der auf dem Chip vorherrschenden Temperatur ist es möglich, die von den licht- und/oder röntgenstrahlenempfindlichen Sensorelementen gelieferten Ausgangssignale hinsichtlich ihres Temperaturverhaltens zu kompensieren, so dass der wahre Wert der absorbierten Strahlungsmenge ermittelt werden kann. Durch die Integration des Temperatursensors in das Chip selbst wird dabei eine maximale Präzision der Temperaturmessung erreicht, welche mit einem extern angeordneten Temperatursensor nicht erzielt werden könnte. Weiterhin lässt sich die Integration eines solchen Temperatursensors besonders kostengünstig im Rahmen der Herstellung des Strahlungssensor-Chips realisieren.

Zur Steigerung der Messgenauigkeit und zur Absicherung gegenüber Ausfällen einzelner Sensoren können auf dem Strahlungssensor-Chip auch mehrere Temperatursensoren verteilt angeordnet werden, so dass gegebenenfalls eine Temperaturverteilung auf dem Chip und/oder eine mittlere Temperatur bestimmt werden können.

Gemäß einer zweiten Variante der Erfindung betrifft diese einen Strahlungssensor in integrierter Bauweise, welcher wiederum mindestens ein licht- und/oder röntgenstrahlenempfindliches Sensorelement enthält, dessen Ausgangssignal die vom Sensorelement absorbierte Strahlungsmenge anzeigt. Der Strahlungssensor enthält weiterhin mindestens ein weiteres Sensorelement, welches für eine andere physikalische Größe als die licht- und/oder röntgenstrahlenempfindlichen Sensorelemente sensitiv ist, wobei die licht- und/oder löntgenstrahlenempfindlichen Sensorelemente und das weitere Sensorelement gleichartige Ausgangssignale liefern und als gleichartige Komponenten an eine Auswerteeinheit angeschlossen werden können.

Bei dem weiteren Sensorelement kann es sich zum Beispiel um einen Sensor für ein Magnetfeld, für eine Beschleunigung, für eine elektromagnetische Strahlung außerhalb des bereits gemessenen Frequenzbereiches (Röntgenstrahlung, wenn die primären Sensorelemente lichtempfindlich sind; Licht, wenn die primären Sensorelemente röntgenstrahlenempfindlich sind; UV; Infrarot; etc.), für eine Kraft beziehungsweise einen Druck oder für chemische Substanzen handeln. Insbesondere kann es sich auch wie oben erläutert um einen Temperatursensor handeln, dessen Ausgangssignal die am Temperatursensor vorherrschende Temperatur anzeigt. Wichtig ist, dass das Ausgangssignal dieses weiteren Sensorelementes prinzipiell von der gleichen Art ist wie das Ausgangssignal der licht- und/oder röntgenstrahlenempfindlichen Sensorelemente, also bei analogen Signalen zum Beispiel ein Spannungssignal, ein Ladungssignal oder ein Stromsignal, oder bei digitalen Signalen ein Signal derselben Bitbreite wie die digitalen Ausgangssignale der Sensorelemente. Die lichtund/oder röntgenstrahlenempfindlichen Sensorelemente und das weitere Sensorelement benutzen demnach dasselbe Datenformat, was eine Voraussetzung dafür schafft, dass sie als gleichartige Komponenten an eine Auswerteeinheit angeschlossen werden können. Die Auswerteeinheit unterscheidet daher nicht danach, ob sie ein Ausgangssignal eines lichtund/oder röntgenstrahlenempfindlichen Sensorelementes oder ein Ausgangssignal des weiteren Sensoielementes einliest. Diese Unterscheidung wird vielmehr allein aus der Adresse der Einheit gewonnen, aus der das Ausgangssignal gelesen wurde. Bei einer typischerweise vorliegenden matrixartigen Anordnung der Sensarelemente erhalten somit die weiteren Sensoidemente in gleicher Weise wie die licht- und/oder löntgenstrahlenempfindlichen Sensorelemente eine bestimmte Adresse, unter welcher ihr Ausgangssignal abgerufen werden kann.

Die erläuterte Auslegung des Strahlungssensors hat den Vorteil, dass keine spezielle Auswertungselektronik für das oder die weiteren Sensorelemente benötigt wird, sondern dass dieses Auslesen von der gleichen Auswerteeinheit vorgenommen werden kann, welche auch für die licht- und/oder röntgenstrahlenempfindlichen Sensorelemente zuständig ist.

Gemäß einer bevorzugten Ausgestaltung sind die licht- und/oder röntgenstrahlenempfindlichen Sensorelemente auf dem Strahlungssensor matrixförmig in Zeilen und Spalten angeordnet. So sind für die Anwendung bei einem Computertomographen in der Regel zwei oder einige wenige lange Zeilen von Sensorelementen nebeneinander angeordnet. Bei Anwendungen im Bereich der dynamischen Röntgendurchleuchtung sind dagegen typischerweise Matrizen mit ca. 2000 x 2000 Seneorelementen vorgesehen.

Für die Auslegung der zusätzlichen Sensorelemente auf den Strahlungssensor-Chip stehen dem Fachmann verschiedene Möglichkeiten zur Verfügung. Im Falle eines Temperatursensors in integrierter Bauweise enthält dieser dabei vorzugsweise einen Stromspiegel mit zwei parallelen Pfaden, in welchen jeweils der gleiche Stromfluss herrscht. In beiden Pfaden ist je ein Bipolar-Transistor mit seiner Emitter-Kollektor-Strecke angeordnet, wobei die Basis dieses Transistors jeweils mit dem Kollektor kurzgeschlossen ist. Die Flächen der ganannten Bipolar-Transistoren sind unterschiedlich groß. Bei einer solchen Anordnung ist der sich in den Strompfaden einstellende Strom in etwa proportional zur Temperatur der Bipolar-Transistoren.

Ein in der geschilderten Weise aufgebauter Temperatursensor kann einen weiteren Stromspiegel parallel zu den beiden genannten Strompfaden aufweisen, wobei der Ausgangsstrom dieses Stromspiegel als Ausgangsstromsignal des Temperatursensors ausgekoppelt und für eine Auswertung verwendet werden kann.

Alternativ oder zusätzlich ist es möglich, auch eine Spannung als Ausgangssignal des Temperatursensors zu gewinnen. Zu diesem Zweck wird vorzugsweise die Differenz zwischen den Emitter-Basis-Spannungen der beiden Bipolar-Transistoren von einer Auskopplungsschaltung ermittelt und dann als Ausgangsspannung für einen externen Abgriff bereitgestellt.

Die Erfindung betrifft weiterhin einen Strahlungsdetektor, welcher als Röntgendetektor insbesondere für den Einsatz in einem Röntgen-Computertomographen geeignet ist. Der Strahlungsdetektor enthält mindestens einen Strahlungssensor der oben erläuterten Art sowie eine zugehörige Auswerteeinheit zum Auslesen und Auswerten der vom Strahlungssensor bereitgestellten Ausgangssignale. Der Strahlungssensor enthält demnach einen auf dem Chip integrierten Temperatursensor oder ein anderes Sensorelement, und vorzugsweise ist das von diesem Sensorelement verwendete Datenformat das gleiche wie dasjenige der licht- und/oder röntgenstrahlenempfindlichen Sensorelemente. Die Auswerteeinheit des bildgebenden Systems kann dann die Ausgangssignale der licht- und/oder röntgenstrahlenempfindlichen Sensorelemente und des anderen Sensorelementes gleichartig behandeln, so dass keine unterschiedlichen Schaltungen für die verschiedenen Sensorelemente erforderlich sind. Die differenzierte Auswertung der verschiedenen Signale wird vielmehr allein über die eingesetzte Software kontrolliert.

Wenn der Strahlungssensor mindestens einen Temperatursensor enthält, ist die Auswerteeinheit vorzugsweise so eingerichtet, dass sie die Ausgangssignale der licht- und/oder röntgenstrahlenempfindlichen Sensorelemente des Strahlungssensors mit Hilfe des vom Temperatursensor gemessenen Temperaturwertes korrigiert. In der Regel hängen die Ausgangssignale eines licht- und/oder röntgenstrahlenempfindlichen Elementes wie zum Beispiel einer Photodiode auf einem CMOS-Chip stark von der auf dem Chip vorherrschenden Temperatur ab. Die Zusammenhänge sind dabei grundsätzlich bekannt, so dass bei Kenntnis der Temperatur rechnerisch oder durch eine geeignete Schaltung eine entsprechende Kompensation für die Temperatur durchgeführt werden kann. Bei der Verwendung des auf dem Mikrochip integrierten Temperatursensors lässt sich dabei eine besonders hohe Präzision der Korrektur erzielen, da der damit erfasste Temperaturwert sehr genau und quasi ohne zeitlichen Verzug der wahren Temperatur des Sensorelementes entspricht.

Weiterhin kann bei Einsatz eines Strahlungssensors mit einem Temperatursensor die Auswerteeinheit so eingerichtet sein, dass sie anhand des gemessenen Temperaturwertes eine Diagnose des Betriebszustandes des Strahlungssensors durchführen kann. So können beispielsweise Fehlfunktionen des Chips oder der Umgebung des Chips zu einer außergewöhnlichen Temperaturerhöhung auf dem Chip führen, welche über den gemessenen Temperaturwert detektiert werden kann. Ebenso kann eine Alterung des Chips aufgrund erhöhter Temperaturen durch den Temperatursensor festgestellt werden. Schließlich ist es bei komplexeren Anordnungen mit mehreren Strahlungssensor-Chips, wie sie insbesondere bei einem Computertomographen zu finden sind, auch möglich, die räumliche Temperaturverteilung festzustellen und dabei ungünstige oder fehlerhafte Temperaturverteilungen in der Anordnung zu erkennen. Durch den Einsatz des Temperatursensors erhöht sich demnach die Zuverlässigkeit des bildgebenden Systems erheblich.

Im Folgenden wird die Erfindung mit Hilfe der Figuren beispielhaft erläutert. Es zeigt:
- Fig. 1: schematisch die Komponenten eines Röntgendetektors gemäß der vorliegenden Erfindung;
- Fig. 2: einen Temperatursensor in integrierter Bauweise mit einem Ausgangsstrom;
- Fig. 3: einen Temperatursensor in integrierter Bauweise mit einer Ausgangsspannung.

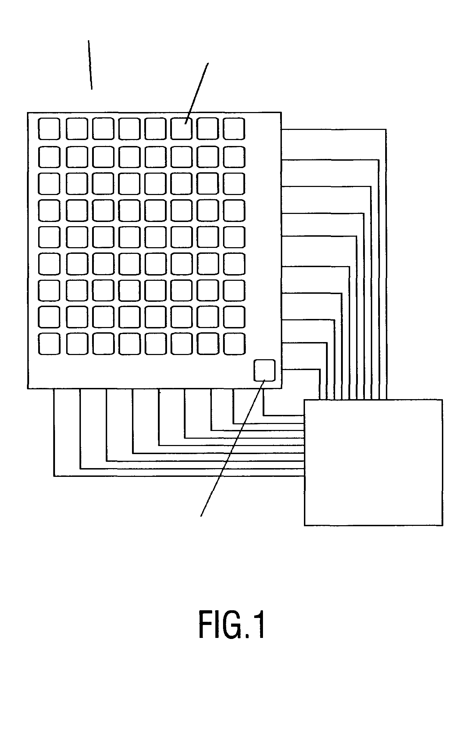

In Figur 1 sind schematisch die Komponenten eines Röntgendetektors dargestellt, wie er zum Beispiel in einem Röntgen-Computertomographen zur Bestimmung des nach Absorption eines Röntgenquants emittierten Fluoreszenzlichtes eingesetzt werden kann. Alternativ könnte der Röntgendetektor auch für einen direkten Nachwis absorbierter Röntgenquanten eingerichtet sein (vgl. DE 42 27 096 A1). Der Röntgendetektor enthält dabei im Wesentlichen einen Strahlungssensor-Chip 10 sowie eine damit verbundene Auswerteeinheit 13. Der Strahlungssensor-Chip 10 ist vorzugsweise in CMOS-Technik hergestellt und enthält auf einer Detektorfläche verteilt matrixartig angeordnete lichtsensitive Sensorelemente 11. Diese können insbesondere als Photodioden realisiert sein, welche an ihrem Ausgang ein Spannungs- und/oder Stromsignal bereitstellen, das im Wesentlichen proportional zur absorbierten Lichtmenge ist. Das Auslesen der genannten Ausgangssignale der Photodioden 11 wird durch die Auswerteeinheit 13 vorgenommen, welche jede Photodiode 11 des Strahlungssensors 10 über ihre Zeile Z und Spalte S adressieren kann.

Bekanntermaßen hängt die von einer Photodiode erzeugte Ausgangsspannung u.a. stark von der Temperatur ab, bei welcher die Photodiode arbeitet. Um diese Abhängigkeit kompensieren und aus dem Ausgangssignal der Photodiode 11 präzise auf die absorbierte Lichtmenge schließen zu können, ist es daher wichtig, die Temperatur der Photodiode 11 möglichst genau zu kennen. Diese Kenntnis der Temperatur wird erfindungsgemäß durch mindestens einen auf dem Chip 10 angeordneten Temperatursensor 12 erlangt. Da sich auf dem Chip 10 in der Regel eine in etwa homogene Temperaturverteilung einstellt, ist die genaue geometrische Anordnung des Temperatursensors 12 weniger kritisch. Anders als in Figur 1 dargestellt kann der Temperatursensor jedoch auch im Mittelpunkt beziehungsweise einem zentralen Bereich des Chips 10 angeordnet werden, um mit Sicherheit einen möglichst repräsentativen Temperaturwert zu bestimmen. Weiterhin können auch mehrere derartige Temperatursensoren vorgesehen sein, aus denen sich das Temperatursignal redundant beziehungsweise als Mittelwert bestimmen lässt. Durch die Integration des Temperatursensois 12 auf dem Mikrochip 10 ist die Temperaturmessung besonders einfach möglich, ohne dass zusätzliche Bauteile oder Komponenten außerhalb des Chips notwendig wären.

Weiterhin ist der Temperatursensor 12 so eingerichtet, dass er von der Auswerteeinheit 13 identisch zu den Photopixeln 11 behandelt werden kann, so dass seine Adressierung, seine Ansteuerung und der Auslesevorgang entsprechend ablaufen können. Insbesondere kann der Temperatursensor 12 wie die Photodioden 11 eine Zeile/Spalte Adresse (Z', S') bekommen, über welche er ansprechbar ist.

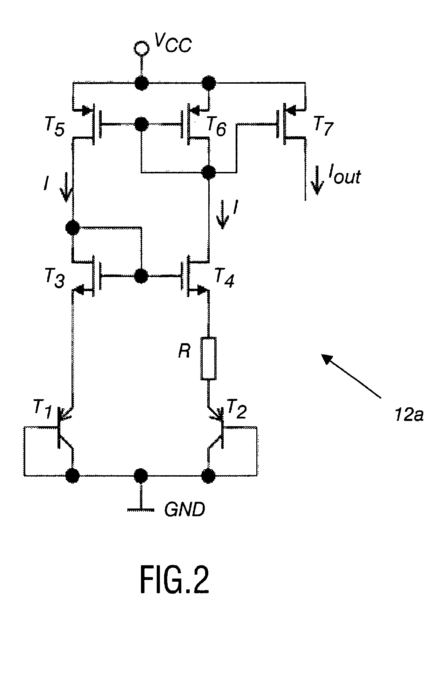

Figur 2 zeigt eine mögliche Schaltung für einen auf einem Chip 10 integrierten Temperatursensor 12a, an dessen Ausgang ein Stromsignal Iₒᵤₜ abgegeben wird. Der gesamte Mikrochip ist dabei in CMOS-Technik realisiert, wobei die CMOS-Transistoren T₃, T₄, T₅ und T₆ einen Stromspiegel darstellen. Der Stromspiegel besteht aus zwei parallelen Strompfaden zwischen der Versorgungsspannung V_{CC} und der Masse GND, nämlich einem ersten Pfad über die Transistoren T₅ und T₃ einerseits und einem zweiten Pfad über die Transistoren T₆ und T₄ sowie den Widerstand R andererseits. Die Transistoren liegen dabei jeweils über ihre Emitter-Kollektor-Strecken in den Strompfaden. Die Basen der Transistoren T₅ und T₆ sowie der Transistoren T₃ und T₄ sind gekoppelt. Ferner sind die Basen der Transistoren T₅ und T₆ mit der Verbindungsleitung zwischen den Transistoren T₆ und T₄ verbunden, und die Basen der Transistoren T₃ und T₄ sind mit der Verbindungsleitung zwischen den Transistoren T₅ und T₃ verbunden. Mit dem Stromspiegel wird der Strom I in den zwei parallelen Strompfaden gleich groß gehalten (zu Stromspiegeln allgemein vgl. U. Tietze, Ch. Schenk, "Halbleiter-Schaltungstechnik"-Kapitel 4.1, 11. Auflage, 1999, Springer-Verlag).

In den beiden Strompfaden ist jeweils noch ein Bipolar-Transistor T₁ bzw. T₂ über die Emitter-Kollektor-Strecke integriert, wobei die Kollektoren jeweils an Masse (GND) angeschlossen sind. Die Bipolar-Transistoren T₁ und T₂ unterscheiden sich nur bei den Flächen um einen Faktor n. Der Widerstand R stellt den Strom I durch die Strompfade ein. Dieser Strom I ist direkt proportional zu der absoluten Temperatur der beiden Bipolar-Transistoren.
Der Strom I wird seinerseits mit Hilfe des CMOS-Transistors T₇ auf den Ausgang als Ausgangsstrom Iₒᵤₜ widergespiegelt, awbei hierbei eventuell auch ein Verstärkungsfaktor zur Anwendung kommen kann.

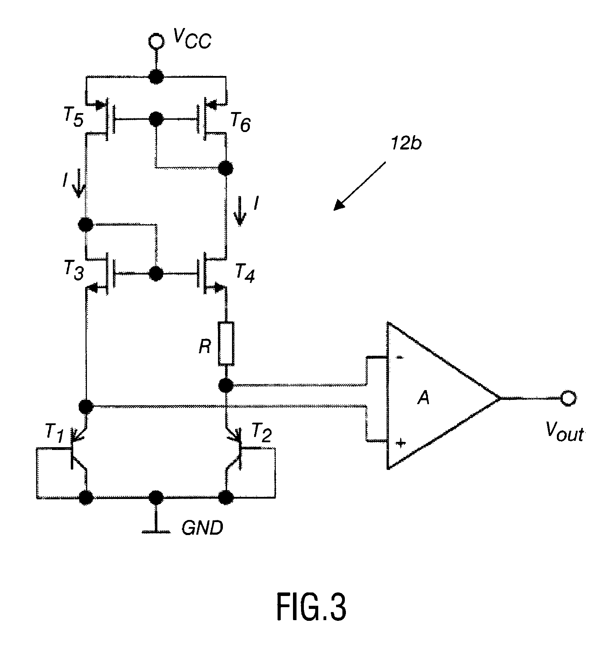

Eine Variante der beschriebenen Schaltung ist als Temperatursensor 12b in Figur 3 dargestellt. Dabei liegt am Ausgang nicht ein Stromsignal, sondern ein Spannungssignal Vₒᵤₜ. In der Schaltung wird mit Hilfe eines Differentialverstärkers A die Differenz der Emitter-Basis-Spannungen der beiden Bipolar-Transistoren T₁ und T₂ ermittelt. Die Ausgangsspannung ist ebenfalls proportional zu der Temperatur beider Transistoren. Wenn der Differentialverstärker einen Verstärkungsfaktor hat, ist es möglich, die Steilheit der Temperaturkennlinie zu beeinflussen.

Bei den Realisierungsmöglichkeiten nach den Figuren 2 und 3 ist die Integration des dargestellten Temperatursensors 12a bzw. 12b dem jeweiligen CMOS-Prozess anzupassen. Sie kann entsprechend optimiert werden, so dass die Sensitivität und der gewünschte Messbereich erreicht werden.

Durch die in den Figuren 1 bis 3 dargestellte Anordnung lassen sich die folgenden Vorteile erzielen:
- erhöhte Genauigkeit für die Temperaturkompensation durch direkte Messung der Chiptemperatur;
- direkter Zugriff auf die Temperaturinformation durch Quasi-Pixeladressierung;
- kein zusätzlicher Aufwand und keine zusätzlichen Kosten für Sensorik und Datenerfassung;
- einheitliches Datenformat;
- hohe lokale Auflösung der Temperatur auf der gesamten Spine (bei der computertomographischen Anwendung) durch Integration des Sensors in jeden Detektorchip;
- Erkennung von ungünstigen Temperaturverteilungen entlang des gesamten Detektorsystems;
- Erkennung von Fehlfunktionen auf dem Chip, die zu außergewöhnlichen Temperaturerhöhungen führen;
Erkennung von vorzeitigen Alterungen durch erhöhte Temperatur.

## Patentansprüche

1. Strahlungssensor (10) in integrierter Bauweise, enthaltend mindestens ein licht- und/oder röntgenstrahlenempfindliches Sensorelement (11), dessen Ausgangssignal die vom Sensorelement absorbierte Strahlungsmenge anzeigt, sowie mindestens einen Temperatursensor (12, 12a, 12b), dessen Ausgangssignal die am Temperatursensor vorherrschende Temperatur anzeigt.

2. Strahlungssensor in integrierter Bauweise, insbesondere nach Anspruch 1, enthaltend mindestens ein licht- und/oder röntgenstrahlenempfindliches Sensorelement (11), dessen Ausgangssignal die vom Sensorelement absorbierte Strahlungsmenge anzeigt, sowie mindestens ein weiteres Sensorelement (12), das für eine andere physikalische Größe als das licht- und/oder röntgenstrahlenempfindliche Sensorelement (11) sensitiv ist, wobei alle Sensorelemente (11, 12) gleichartige Ausgangssignale liefern und als gleichartige Komponenten an eine Auswerteeinheit (13) angeschlossen werden können.

3. Strahlungssensor nach Anspruch 1 oder 2,
**dadurch gekennzeichnet,**
**dass** die licht- und/oder röntgenstrahlenempfindlichen Sensorelemente matrixartig auf dem Strahlungssensor angeordnet sind.

4. Strahlungssensor nach mindestens einem der Ansprüche 1 bis 3,
**dadurch gekennzeichnet,**
**dass** er einen Temperatursensor (12a, 12b) aufweist, welcher einen Stromspiegel mit zwei Pfaden (T₃-T₅, T₄-T₆) enthält, wobei sich in den beiden Pfaden jeweils ein Bipolar-Transistor (T₁, T₂) befindet, dessen Basis mit dem Kollektor kurzgeschlossen ist, und wobei die Flächen dieser Bipolar-Transistoren unterschiedlich groß sind und der Strom (I) in den Strompfaden der Temperatur der Bipolar-Transistoren in etwa proportional ist.

5. Strahlungssensor nach Anspruch 4,
**dadurch gekennzeichnet,**
**dass** der Strom (I) in den Strompfaden über einen weiteren Stromspiegel (T₇) als Ausgangsstrom (Iₒᵤₜ) ausgekoppelt wird.

6. Strahlungssensor nach Anspruch 4 oder 5,
**dadurch gekennzeichnet,**
**dass** die Differenz zwischen den Emitter-Basis-Spannungen der Bipolar-Transistoren (T₁, T₂) von einer Auskopplungsschaltung (A) ermittelt und als Ausgangsspannung (Vₒᵤₜ) bereitgestellt wird.

7. Strahlungsdetektor, insbesondere Röntgendetektor für einen Computertomographen, enthaltend mindestens einen Strahlungssensor (10) nach mindestens einem der Ansprüche 1 bis 6 sowie eine zugehörige Auswerteeinheit (13) zum Auslesen und Auswerten der vom Strahlungssensor bereitgestellten Ausgangssignale.

8. Strahlungsdetektor nach Anspruch 7,
**dadurch gekennzeichnet,**
**dass** der Strahlungssensor (10) einen Temperatursensor (12, 12a, 12b) enthält, und dass die Auswerteeinheit (13) so eingerichtet ist, dass sie die Ausgangssignale der licht- und/oder röntgenstrahlenempfindlichen Sensorelemente (11) des Strahlungssensors mit Hilfe des vom Temperatursensor gemessenen Temperaturwertes korrigiert.

9. Strablungsdetektor nach Anspruch 7 oder 8,
**dadurch gekennzeichnet,**
**dass** der Strahlungssensor (10) einen Temperatursensor (12, 12a, 12b) enthält, und dass die Auswerteeinheit (13) so eingerichtet ist, dass sie anhand des vom Temperatursensor gemessenen Temperaturwertes eine Diagnose betreffend Fehler und/oder eine Alterung des Strahlungssensors (10) ausführen kann.

10. Röntgenuntersuchungsgerät mit einem Strahlungsdetektor, insbesondere einem Röntgendetektor, enthaltend mindestens einen Strahlungssensor (10) nach mindestens einem der Ansprüche 1 bis 6 sowie eine zugehörige Auswerteeinheit (13) zum Auslesen und Auswerten der vom Strahlungssensor bereitgestellten Ausgangssignale.
